# EUROPEAN PATENT APPLICATION

(11) **EP 1 793 273 A1**
(43) Date of publication of application: **06.06.2007**
(21) Application number: 05077749.9
(22) Date of filing: 02.12.2005
(51) Int. Cl.: G03F 7/00

(54) **Method of direct microcontact printing of a pattern on a substrate, the substrate obtainable and the use of such substrate**

(71) Applicant: University of Twente, 7500 AE Enschede (NL)
(72) Inventor: Rozkiewicz, Dorota Idalia, 7522 CH Enschede (NL); Reinhoudt, David Nicolaas, 7552 GD Hengelo (NL); Ravoo, Bart Jan, 7511 EX Enschede (NL)
(74) Representative: Prins, Hendrik Willem

(57) **Abstract**

The Invention relates to a method of direct microcontact printing of a pattern on a substrate, comprising the steps of providing a flexible plastic substrate, providing a flexible stamp having at least part of the pattern, inking the stamp pattern with an ink comprising a complex of a substrate contact component and a pattern forming component and microcontact printing the inked stamp pattern by conformal contact on the plastic substrate.

The invention also relates to a substrate provided with a pattern obtained by the method and to the use of such a substrate.

## Description

The present invention relates to a method of direct microcontact printing of a pattern on a substrate, to the substrate provided with such pattern and obtainable by such method, and to the use of such substrate in various technologies.

In various types of displays and electronic circuits it is the objective to create a pattern (or structure) on a substrate such that the created structure has nanometer resolution in the range of about 100nm. This resolution should be stable during the subsequent handling and manipulation of the substrate towards an endproduct, and during the subsequent use of the endproduct.

It is a further objective that such method of forming such nanometer pattern on a substrate is reliable, simple in use and does not require costly and/or time consuming conditions.

The present invention has for its object to provide a method of direct contact printing which substantially complies with the above identified objections and substantially avoids the above identified disadvantages.

Accordingly, the present invention provides a method of direct microcontact printing of a pattern on a substrate, comprising the steps of:
i) providing a flexible plastic substrate;
ii) providing a flexible stamp having at least part of the pattern;
iii) inking the stamp pattern with an ink comprising a complex of a substrate contact component and a pattern forming component; and
iv) microcontact printing the inked stamp pattern by conformal contact on the plastic substrate.

This method according to the invention is based on the insight that by direct conformal contact on molecular level of the inked pattern on the stamp with the plastic substrate a high resolution printing of the substrate is obtainable. Furthermore, the ink preparation comprises a complex of a substrate contact component and a pattern forming component. The substrate contact component is the vehicle that transfers the pattern forming component from the stamp onto the substrate and binds the pattern forming component of the substrate. Thus, the complex of substrate contact component and pattern forming component is such that the two components will not decomplex, at least not during the inking and stamping steps until the ink is fixed on the plastic substrate.

In order to meet the requirement of conformal contact printing, the plastic substrate and the stamp should both have a sufficient flexibility allowing intimate contact until on molecular level. Accordingly, the ink pattern on the stamp is then mechanically and conformally imprinted and contacted to the plastic substrate.

Due to the conformal contact at molecular level it is feasible to have on the stamp a pattern with a nanometer resolution (formed by known technologies such as lithography and the like) which with substantial maintenance of this nanometer resolution is transferred onto the plastic substrate where due to the contact at molecular level the inked preparation is adhered and fixed to the plastic substrate by the substrate contact component. This substrate contact component fixed to the plastic substrate at the same time as a vehicle or as an intermediate fixes the pattern forming component to the substrate. Accordingly, the nanometer pattern is thereby elegantly and simply transferred from the stamp onto the plastic substrate.

In order to improve the stability of the pattern on the plastic substrate during further handling and use, it is preferred to subject the plastic substrate provided with the pattern to a heat treatment. Such a heat treatment, dependent on the type of substrate material used would comprise a heat treatment by heating to a temperature from 40-180°C, preferably 60-160°C, such as 80-120°C. Obviously, the heat treatment temperature is furthermore dependent on the type of inked preparation used.

In order to avoid mechanical erosion of the pattern on the plastic substrate, in particular during use, it is preferred that the pattern on the plastic substrate is covered by a transparent plastic layer thereby forming a laminate. Accordingly, the pattern is protected against mechanical and environmental impacts.

According to another embodiment of the present invention it is possible that one plastic substrate is provided at both sides with at least a part of the required pattern. In the alternative, two or more plastic substrate may be provided with at least a part of the pattern. Accordingly, two side printing of the plastic substrate or layering several plastic substrates and thereby forming a laminate will provide the complete pattern. Such laminate may be provided with a covering sheet. The laminates may then be heat treated in order to arrive at a single multi-substrate suitable for the desired end use. In this respect it is noted that in such laminate the pattern parts may be mutually facing or facing in opposite directions, dependent on which additional use of a cover layer in the laminate is required.

The substrate contact component which functions as a vehicle for the pattern forming component from the stamp onto the plastic substrate and stick the pattern forming component may be a chemical molecule of quite diverse composition. Examples comprise a dendrimer, branched polymer and protein.

A dendrimer is preferred when it has an outer functional property suitable for binding to the plastic substrate, and an (same or different) inner functional property for binding the pattern forming component to the substrate contact component. However, the pattern forming component may be adhered to the outer surface of the substrate contact component but preferably is arranged in the substrate contact component. For instance, by encapsulation or by inner covalent bonding.

Suitable dendrimers are poly (propylene imine) dendrimers, polypropyleneimine diaminobutane dendrimers, branched polymers, such as star-branched polymers for example type: 3-arm ABC, 4-arm ABCD, A2B2 wherein A-polystyrene, B-poly(a-methylstyrene), C-poly(4-methylstyrene), proteins and peptides such as albumin, collagen, and gelatin.

The pattern forming component may be of such nature that in the final use its presence on the plastic substrate is discernable, such as visual or after activation by irradiation (UV and/or IR). Preferred pattern forming components comprise a dye, such as rhodamine and the like. In addition or in the alternative the pattern forming component may comprise nanosized metal particles, such as gold particles and palladium particles. Such nanosized metal particles may be deposited as such on or in the substrate contact component or may be formed by electrodeposition. Preferably, the pattern forming component is covalently bond to the substrate contact component. The flexible stamp provided with at least part of the pattern and used for inking the stamp pattern with an ink preparation and transfer the inked stamp pattern by microcontact printing on the plastic substrate should be as indicated above of sufficient flexibility to allow molecular conformal contact. Suitable materials for the stamp comprise comprises poly (dimethylsiloxane), oxidized poly(dimethylsiloxane), SEBS (=poly(styrene-b-(ethylene-cobutylene)-b-styrene), rubber (such as latex, poly(cis-1,4-isoprene) or poly(isoprene) also any natural rubbers).

Preferably, the flexible plastic substrate is transparent such that during use the pattern directly or after activation is visual. Suitable flexible plastic substrates comprise transparent PVC foil, overhead transparencies, transparent foil for printers, any foil-like transparent, flat, flexible polymer, polyester films, PMMA Poly(methyl methacrylate), methacrylate copolymers, styrenic polymers, high refractive index polymers, fluorine-containing polymers, polyethersulfone, polyimides containing an alicyclic structure.

Another aspect of the present invention relates to a flexible plastic substrate provided by the method according to the invention with the ink pattern.

A final aspect of the present invention relates to the use of such a substrate in a display, in intermediates in display technology and to flexible electronic circuits.

Mentioned and other features of the method and substrate according to the present invention will be further explained in the following examples which are given for illustrative purposes and not intended to limit to any extent the scope of the present invention.

### Example 1

A plastic foil (Leitz Germany, product number 4191-00-35) was used for micrometer-size metal structure printing. The foil was soaked in ethanol for two hours, rinsed with methanol and dried with a stream of nitrogen gas.

The ink preparation comprises 1 mM ethanol solution of poly(propylene imine) dendrimers, generation 5, with covalently bond rhodamine B dye. The rhodamine B dye was covalently bond by reacting the dendrimer with 8 equivalents rhodamine B isothiocyanate.

For microcontact printing this fluorescent ink preparation use was made of a stamp made of poly(dimethylsiloxane, PDMS) obtained from dow corning. The stamp was provided with a micrometer-size structure and immersed for 1 minute in the ink preparation. Subsequently, the stamp is dried for 1 minute in a stream of nitrogen gas.

The microcontact printing of the pattern on this PDMS stamp is carried out by conformal contacting the stamp with the substrate for 1 minute.

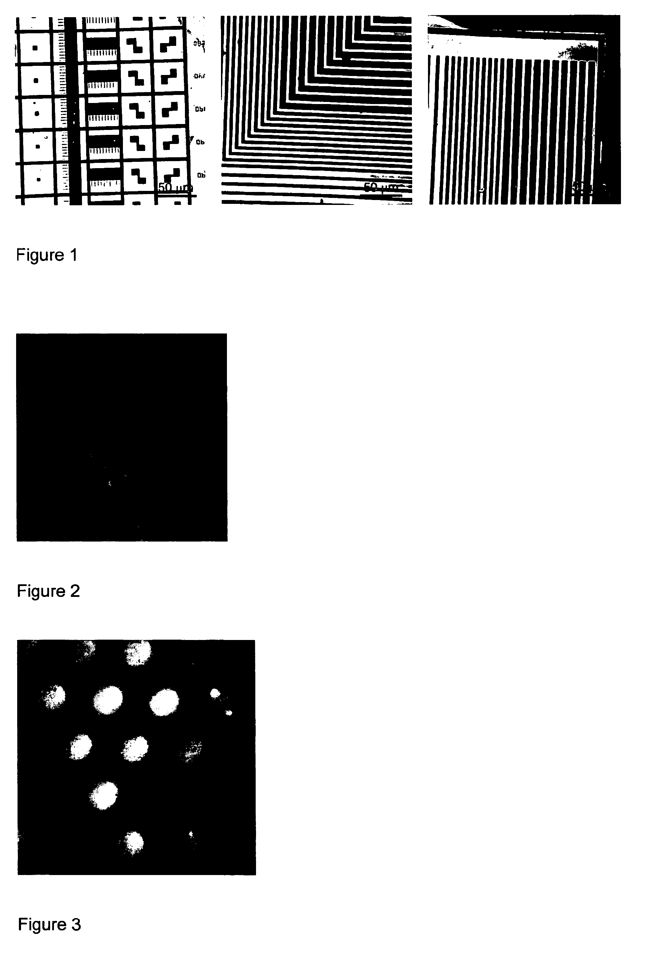

After this contact time the stamp is lifted and the substrate is ready for imaging under a fluorescent microscope. The fluorescent microscopy was performed with a Zeiss LSM 210 microscope using a HeNe laser beam (543 nm wavelength). The ink preparation printed as a micrometer pattern on the foil is shown in figure 1. Figure 1 shows the LSM image of the various inked preparation patterns printed on the foil.

### Example 2

The stability of the pattern formed on the foil substrate in example 2 is tested for stability. Directly after printing the foil provided with the pattern of the ink preparation of example 1 is subjected to washing with water. As shown in figure 2 it is clear that the ink preparation is strongly adhered through the foil substrate by the dendrimers as substrate contact component. Figure 2 shows some minor diffusion or spreading of the imprinted pattern.

### Example 3

A substrate provided with the ink preparation according to example 1 is subjected to a heat treatment in order to improve the stability of the imprinted microsized pattern on the foil substrate. The heat treatment comprises a heat treatment at a temperature up to 120°C by placing the imprinted substrate on a hot plate.

Subsequently, the heat treated substrate is rinsed with water. Figure 3 shows that the water treatment did not result in any diffusion or spreading of the imprinted pattern on the substrate.

### Example 4

The ink preparation comprises dendrimers of example 1 and as the pattern forming component gold nanoparticles encapsulated in the dendrimers.

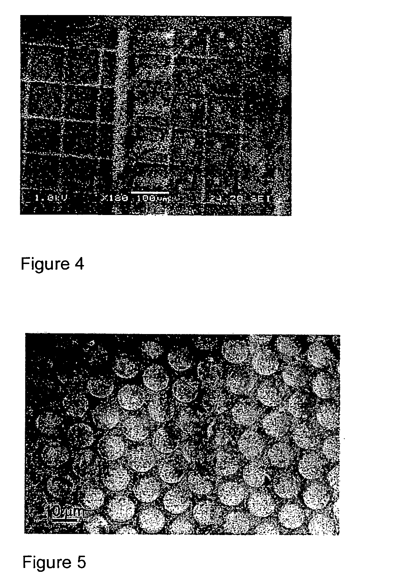

The same PDMS stamp was immersed in the same ink solution as used in example 1. Subsequently, a solution (0.01 M aqueous solution of HAuCl₄ was placed on the stamp provided with the ink solution. After 15 minutes the stamp was dried in a nitrogen gas stream and a 0.1 M aqueous solution of NaBH₄ was applied on the stamp. Subsequently, the stamp is dried in nitrogen gas stream and the same foil is microcontact printed with the inked stamp pattern. The imprinted foil substrates have been examined with SEM microscopy. Images are shown in figure 4. Figure 4 are SEM images of the pattern of Rh-Dab-G5 after encapsulation of gold nanoparticles.

### Example 5

Dendrimers Dab, generation 5, covalently labeled with rhodamine in ratio 8:1 were provided with gold nanoparticles. The nanoparticle composition was prepared as follows. 0.5 ml of a 0.15 aqueous dendrimer solution was diluted to 2 ml and 0.5 ml of a 0.01 M aqueous HAuCl₄ solution was slowly added under vigorous stirring. Subsequently, 0.2 ml of a 0.1 M solution of NaBH₄ was in water was added under vigorous stirring. This ink preparation comprising gold nanoparticles was placed on the PDMS stamp for 5 minutes. Subsequently, the stamp was dried and brought in conformal contact with the substrate. The substrate is provided with a microsized rhodamine/gold nanoparticles structure. The patterns were similar to the patterns in the figures 3 and 4.

It is noted that the dendrimers may also be used without the fluorescent dye.

## Claims

1. Method of direct microcontact printing of a pattern on a substrate, comprising the steps of:
v) providing a flexible plastic substrate;
vi) providing a flexible stamp having at least part of the pattern;
vii) inking the stamp pattern with an ink comprising a complex of a substrate contact component and a pattern forming component; and
viii) microcontact printing the inked stamp pattern by conformal contact on the plastic substrate.

2. Method as claimed in claim 1, wherein the plastic substrate provided with the pattern is subjected to a heat treatment.

3. Method as claimed in claim 1 or 2, wherein the pattern on the plastic substrate is covered by a transparent plastic layer thereby forming a laminate.

4. Method as claimed in claim 1-3, wherein at least two plastic substrates comprising an inked pattern are laminated.

5. Method as claimed in claim 1-4, wherein the substrate contact component comprises a dendrimer, a branched polymer, and/or a protein.

6. Method as claimed in claim 1-5, wherein the pattern forming component comprises a dye and/or nanosized metal particles.

7. Method as claimed in claim 1-6, wherein the stamp comprises poly (dimethylsiloxane), oxidized poly(dimethylsiloxane), SEBS (=poly(styrene-b-(ethylene-cobutylene)-b-styrene), rubber.

8. Method as claimed in claim 1-7, wherein the flexible plastic substrate is transparent.

9. Substrate provided with a pattern obtainable by the method of claim 1-8.

10. Use of a substrate of claim 9 or as obtainable by the method of claim 1-8 in a display, multicolor print, electronic circuit, intermediate in a display.
